# FASCICULE DE BREVET EUROPEEN

(11) **EP 4 472 395 B1**
(45) Date de publication et mention de la délivrance du brevet: **18.02.2026**
(21) Numéro de dépôt: 24178242.4
(22) Date de dépôt: 27.05.2024
(51) Int. Cl.: H10N 70/00, H10N 70/20, H10B 63/10, H10B 63/00, G11C 11/56, G11C 13/00

(54) **DISPOSITIF ELECTRONIQUE**
ELEKTRONISCHE VORRICHTUNG
ELECTRONIC DEVICE

(30) Priorité: 31.05.2023 FR 2305439
(43) Date de publication de la demande: 04.12.2024
(73) Titulaire: STMicroelectronics International N.V., 1228 Plan-les-Ouates, Geneva (CH)
(72) Inventeur: BOIVIN, Philippe, 13770 VENELLES (FR); JEANNOT, Simon, 38000 GRENOBLE (FR)
(74) Mandataire: Cabinet Beaumont

(56) Documents cités:
- FR-A1- 3 115 931
- FR-A1- 3 115 932
- US-A1- 2014 264 244

## Description

### Domaine technique

La présente description concerne de façon générale les dispositifs électroniques et plus particulièrement les dispositifs électroniques comprenant des cellules mémoires, plus particulièrement des cellules mémoire à changement de phase.

### Technique antérieure

Dans une mémoire à changement de phase usuelle, par exemple, chaque cellule mémoire comprend une couche de matériau à changement de phase qui est en contact avec un élément résistif. Les matériaux à changement de phase sont des matériaux qui peuvent basculer entre une phase cristalline et une phase amorphe. Ce basculement est provoqué par une augmentation de la température de l'élément résistif dans lequel on fait passer un courant électrique. La différence de résistance électrique entre la phase amorphe du matériau et sa phase cristalline est utilisée pour définir au moins deux états de mémoire, arbitrairement 0 et 1.

Les mémoires sont généralement sous forme de matrices, comprenant des lignes de mot ("wordline") et des lignes de bit ("bitline"), c'est-à-dire des lignes et des colonnes. Une cellule mémoire, contenant une information binaire, se situe à chaque croisement d'une ligne et d'une colonne.

L'information contenue dans une cellule d'une mémoire à changement de phase est par exemple accédée, ou lue, en mesurant la résistance entre la ligne de bit et la ligne de mot de la cellule mémoire.

Les cellules mémoire à changement de phase sont par exemple situées dans un réseau d'interconnexion. Par réseau d'interconnexion, on entend un empilement de couches isolantes, formées durant les étapes de fabrication dites "back end of line", dans lequel sont situées des pistes métalliques reliées entre elles par des vias conducteurs. De préférence, les niveaux du réseau d'interconnexion, comprenant chacun des pistes conductrices dans une couche isolante et des vias conducteurs dans une couche isolante, ont une hauteur constante. Cependant, les cellules mémoire connues sont trop haute pour être placées entre certains niveaux sans modifier localement la hauteur du niveau.

Il existe un besoin pour des cellules mémoire à changement de phase ayant une hauteur inférieure aux cellules mémoire à changement de phase connues, de telle manière qu'elles puissent être situées entièrement dans un niveau d'un réseau d'interconnexion.

Des exemples de l'art antérieur sont décrits par US 2014 / 0264244 A1, FR 3 115 931 A1 et FR 3 115 932 A1.

### Résumé de l'invention

Un mode de réalisation pallie tout ou partie des inconvénients des dispositifs électroniques comprenant des cellules mémoire à changement de phase connus.

Un mode de réalisation prévoit un dispositif comprenant une cellule mémoire à changement de phase, la cellule mémoire comprenant un premier empilement de couches, le premier empilement de couches comprenant une couche intermédiaire de matériau à changement de phase, une couche inférieure isolante et une couche supérieure isolante, la cellule comprenant des premier et deuxième éléments conducteurs ayant une forme de L, le premier élément s'étendant sur une première paroi latérale du premier empilement, le deuxième élément s'étendant sur une deuxième paroi latérale de l'empilement opposée à la première paroi. La couche intermédiaire de l'empilement de couches est configurée pour qu'un état parmi cristallin et amorphe d'au moins une région de la couche intermédiaire détermine un état programmé de la cellule à changement de phase.

Un autre mode de réalisation prévoit un procédé de fabrication d'un dispositif comprenant une cellule mémoire à changement de phase, le procédé comprenant une étape de formation d'un premier empilement de couches, le premier empilement de couches comprenant une couche intermédiaire de matériau à changement de phase, une couche inférieure isolante et une couche supérieure isolante, le procédé comprenant en outre la formation de premier et deuxième éléments conducteurs ayant une forme de L, le premier élément s'étendant sur une première paroi latérale du premier empilement, le deuxième élément s'étendant sur une deuxième paroi latérale du premier opposée à la première paroi. La couche intermédiaire de l'empilement de couches est configurée pour qu'un état parmi cristallin et amorphe d'au moins une région de la couche intermédiaire détermine un état programmé de la cellule à changement de phase.

Selon un mode de réalisation, la couche intermédiaire a une épaisseur comprise entre 5 nm et 50 nm.

Selon un mode de réalisation, le dispositif comprend un réseau d'interconnexion, la cellule étant située entre un niveau inférieur et un niveau supérieur du réseau d'interconnexion, les niveaux inférieur et supérieur étant successifs.

Selon un mode de réalisation, le premier élément conducteur comprend une partie horizontale reposant sur un troisième élément conducteur du niveau inférieur et une partie verticale s'étendant sur la paroi latérale du premier empilement.

Selon un mode de réalisation, un quatrième élément conducteur du niveau supérieur est en contact avec une extrémité supérieure d'une partie verticale du deuxième élément.

Selon un mode de réalisation, un cinquième élément conducteur s'étend du niveau supérieur à une partie horizontale du deuxième élément conducteur.

Selon un mode de réalisation, le procédé comprend la formation du niveau d'interconnexion inférieur, la formation d'un deuxième empilement de couches comprenant une première couche en un matériau à changement de phase entre deux deuxièmes couches isolantes, la formation de cavités traversant le deuxième empilement de manière à former le premier empilement, une paroi de chaque premier empilement étant située sur un troisième élément.

Selon un mode de réalisation, le procédé comprend la formation de manière conforme d'une troisième couche en le matériau des premier et deuxième éléments, la formation d'espaceurs sur les parois latérales du premier empilement et la gravure des portions de la troisième couche n'étant pas situées sous les espaceurs.

Selon un mode de réalisation, le dispositif comprend au moins deux cellules dont les couches intermédiaires ont des épaisseurs différentes.

Selon un mode de réalisation, la couche intermédiaire d'une des cellules a une épaisseur comprise entre 5 nm et 50 nm et dans lequel la couche intermédiaire de l'autre des cellules a une épaisseur comprise entre 10 nm et 100 nm.

Selon un mode de réalisation, le procédé comprend une étape de formation d'une couche d'épaisseur égale à la différence entre les épaisseurs des couches intermédiaires des deux cellules sur l'emplacement de la cellule ayant l'épaisseur la plus grande.

Selon un mode de réalisation, le dispositif comprend des sixièmes éléments conducteurs en forme de L s'étendant à travers la couche inférieure du premier empilement.

Selon un mode de réalisation, le dispositif comprend des septièmes éléments conducteurs en forme de L s'étendant à travers la couche supérieure du premier empilement.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'un dispositif électronique comprenant des cellules mémoire ;
la figure 2, la figure 3, la figure 4, la figure 5, la figure 6 et la figure 7 représentent des étapes d'un procédé de fabrication du mode de réalisation de la figure 1 ;
la figure 8A représente un autre mode de réalisation d'un dispositif électronique comprenant des cellules mémoire ;
la figure 8B représente différents états d'un exemple de cellule mémoire selon le mode de réalisation de la figure 8A ;
la figure 9 représente une étape du procédé de fabrication du mode de réalisation de la figure 8 ;
la figure 10 représente un autre mode de réalisation d'un dispositif électronique comprenant des cellules mémoire ;
la figure 11 représente un autre mode de réalisation d'un dispositif électronique comprenant des cellules mémoire ;
la figure 12, la figure 13, la figure 14 et la figure 15 représentent des états possibles du mode de réalisation de la figure 11 ; et
la figure 16 représente un autre mode de réalisation d'un dispositif électronique comprenant des cellules mémoire.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

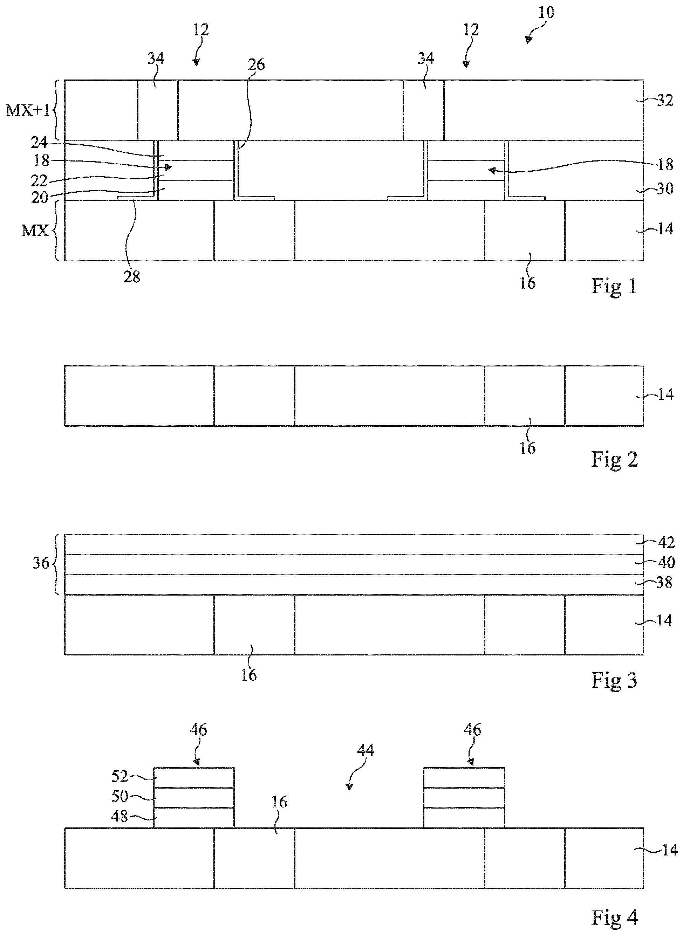

La figure 1 représente un mode de réalisation d'un dispositif électronique 10 comprenant des cellules mémoire 12. Le dispositif 10 comprend par exemple une pluralité de cellules 12. Les cellules 12 sont par exemple agencées en matrice. Dans l'exemple de la figure 1, seules deux cellules 12 sont représentées. Les deux cellules sont des cellules voisines d'une même ligne ou d'une même colonne de la matrice. Par exemple, les deux cellules sont reliées par une même ligne de bit.

Le dispositif 10 comprend une couche isolante 14. La couche isolante 14 est par exemple en oxyde de silicium. La couche 14 est traversée par des éléments conducteurs 16. Les éléments 16 sont par exemple en métal, par exemple en cuivre. Les éléments 16 s'étendent de préférence sur toute la hauteur de la couche 14. Les éléments 16 ont par exemple une extrémité supérieure coplanaire avec la face supérieure de la couche 14.

La couche 14 et les éléments 16 correspondent par exemple à un niveau de métallisation MX d'un réseau d'interconnexion. Les éléments 16 ont par exemple une extrémité inférieure reliée, par un via traversant une couche isolante séparant les niveaux de métallisation MX et Mx-1, avec une métallisation, c'est-à-dire une bande métallique, s'étendant dans le niveau de métallisation MX-1. Chaque élément 16 a par exemple une forme de bande s'étendant dans la direction d'une ligne de mot, chaque cellule de la même ligne de mot étant reliée à l'élément 16.

Le niveau MX est par exemple le niveau inférieur M1 d'un réseau d'interconnexion, c'est-à-dire le niveau le plus proche d'un substrat semiconducteur non représenté. Par exemple, des éléments de sélection, par exemple des transistors, sont formés dans et sur le substrat non représenté. Les éléments 16 ont par exemple une extrémité inférieure reliée, par un vias traversant une couche isolante séparant la couche 14 au substrat non représenté, avec le substrat non représenté. Par exemple, l'extrémité inférieure de chaque élément 16 est reliée à une borne d'un élément de sélection.

Chaque cellule 12 comprend un empilement 18 de couches. Les couches de l'empilement 18 ont de préférence des dimensions horizontales, c'est-à-dire dans un plan parallèle à la face supérieure de la couche 14, sensiblement identiques. Les couches de l'empilement 18 ont des parois latérales coplanaires les unes avec les autres. Les parois latérales de l'empilement 18 sont ainsi planes.

L'empilement 18 repose sur la couche 14 et sur un des éléments 16. Plus précisément, une paroi latérale de l'empilement 18 est située sur la face supérieure d'un élément 16. Une autre paroi latérale de l'empilement, de préférence la paroi opposée à la paroi située sur l'élément 16, est située sur la couche isolante 14, de préférence uniquement sur la couche 14.

Chaque empilement 18 comprend une couche inférieure 20. La couche 20 est une couche isolante, par exemple en oxyde de silicium. La couche 20 s'étend sur l'élément 16 et sur la couche 14.

Chaque empilement 18 comprend une couche intermédiaire 22. La couche 22 est en un matériau à changement de phase, par exemple un alliage de germanium, d'antimoine et de tellure (GST). Le couche 22 est située sur la couche 20, de préférence en contact avec la couche 20. De préférence, la couche 22 recouvre entièrement la face supérieure de la couche 20. De préférence, la face inférieure de la couche 22 est entièrement en contact avec la face supérieure de la couche 20.

Chaque empilement 18 comprend une couche supérieure 24. La couche 24 est une couche isolante, par exemple en oxyde de silicium. Le couche 24 est située sur la couche 22, de préférence en contact avec la couche 22. De préférence, la couche 24 recouvre entièrement la face supérieure de la couche 22. De préférence, la face inférieure de la couche 24 est entièrement en contact avec la face supérieure de la couche 22.

Par exemple, chaque empilement 18 ne comprend que les couches 20, 22, 24. Par exemple, chaque empilement 18 ne comprend pas d'autre couche conductrice ou semiconductrice que la couche 22.

De préférence, toutes les couches 20 ont la même épaisseur. Similairement, toutes les couches 22 ont de préférence la même épaisseur. Les couches 24 ont de préférence la même épaisseur.

Chaque cellule 12 comprend deux éléments résistifs 26 et 28. Les éléments 26 et 28 ont une forme de **L.** Autrement dit, les éléments 26 et 28 comprennent chacun une partie horizontale, de préférence plane, et une partie verticale, de préférence plane.

L'élément 26 est situé sur l'élément 16 associé à la cellule. Plus précisément, la partie horizontale de l'élément 26 s'étend au moins partiellement, de préférence entièrement, sur l'élément 16. Ainsi, la face inférieure de la partie horizontale de l'élément 26 est en contact avec l'élément 16. La partie verticale de l'élément 26 s'étend sur la paroi latérale de l'empilement 18. Plus précisément, la partie verticale de l'élément 26 s'étend sur la paroi latérale de l'empilement 18 situé sur l'élément 16. La partie verticale de l'élément 26 s'étend au moins sur la paroi latérale de la couche 20 et sur au moins une partie de la paroi latérale de la couche 22. De préférence, la partie verticale de l'élément 26 s'étend sur toute la paroi latérale de l'empilement 18, c'est-à-dire sur toute la paroi latérale de la couche 20, de la couche 22 et de la couche 24. La face supérieure de la partie verticale de l'élément 26 est par exemple coplanaire avec la face supérieure de l'empilement 18.

L'élément 28 est située sur la couche 14. Plus précisément, la partie horizontale de l'élément 28 s'étend sur la couche 14, de préférence au pied de la paroi latérale de l'empilement 18 opposée à la paroi sur laquelle repose l'élément 26. Ainsi, la face inférieure de la partie horizontale de l'élément 28 est uniquement en contact avec la couche 14. La partie verticale de l'élément 28 s'étend sur la paroi latérale de l'empilement 18. Plus précisément, la partie verticale de l'élément 28 s'étend sur la paroi latérale de l'empilement 18 opposée à la paroi sur laquelle repose l'élément 26. La partie verticale de l'élément 28 s'étend sur toute la paroi latérale de l'empilement 18, c'est-à-dire sur toute la paroi latérale de la couche 20, de la couche 22 et de la couche 24. Ainsi, la partie verticale de l'élément 28 s'étend sur toute la hauteur de la paroi latérale de l'empilement 18, et atteint le niveau de la face supérieure de l'empilement 18.

Les cellules 12, plus précisément les empilements 18 et les éléments 26, 28 associés, sont entourés par une couche isolante 30. Ainsi, la couche 30 sépare les cellules 12, plus précisément les empilements 18 et les éléments 26, 28 associés, les unes des autres. Chaque empilement 18 correspond de préférence à une unique cellule 12. Les empilement 18 de chaque cellule comprennent des parois latérales, non recouvertes par les éléments 26, 28, recouvertes par la couche 30.

La couche 30 s'étend sur toute la hauteur de l'empilement 18. Ainsi, la face supérieure de la couche 30 est par exemple coplanaire avec la face supérieure de l'empilement 18, et plus particulièrement avec la face supérieure de la couche 24.

Le dispositif 10 comprend une couche isolante 32. La couche isolante 32 est par exemple en oxyde de silicium. La couche 32 correspond par exemple à une couche d'un réseau d'interconnexion. La couche 32 est traversée par des éléments conducteurs 34. Les éléments 34 sont par exemple en métal, par exemple en cuivre. La couche 32 et les éléments 34 correspondent par exemple à un niveau de métallisation, par exemple le niveau MX+1. Les cellules 12 sont ainsi situées entre deux niveaux successifs du réseau d'interconnexion.

Les éléments 34 s'étendent de préférence sur toute la hauteur de la couche 32. Les éléments 34 ont par exemple une extrémité inférieure coplanaire avec la face supérieure de la couche 32. Chaque élément 34 a une extrémité inférieure en contact avec la face supérieure d'un élément 28. Les éléments 34 ont par exemple une extrémité supérieure reliée, par un via, avec une métallisation d'un niveau MX+2.

Lors de la programmation de chaque cellule mémoire, un courant est transmis entre l'élément 16, par exemple relié à une ligne de mot, et l'élément 34, par exemple relié à une ligne de bit. Le courant entraine la chauffe des élément résistifs 26, 28 et ainsi la chauffe du matériau à changement de phase de la couche 22. Le matériau à changement de phase bascule ainsi entre la phase cristalline et la phase amorphe.

De préférence, la couche 22 et les éléments 26, 28 ont des dimensions permettant de créer un confinement thermique dans la couche 22. Par exemple, la couche 22 a une épaisseur inférieure à l'épaisseur de la portion verticale des éléments 26, 28, par exemple comprise entre 5 nm et 20 nm. Alternativement, les éléments 26, 28 peuvent être en un matériau moins résistif que le matériau de la couche 22, par exemple en tungstène ou en nitrure de titane.

L'épaisseur de l'empilement 18 peut être telle que la distance entre les couches 14 et 32 correspond à l'épaisseur d'un niveau d'un réseau d'interconnexion dans les technologies metal-oxyde-semiconducteur complémentaire ou CMOS (Complementary metal-oxide-semiconductor). Par exemple l'empilement 18 a une épaisseur comprise entre 100 nm et 700 nm.

La figure 2, la figure 3, la figure 4, la figure 5, la figure 6 et la figure 7 représentent des étapes, de préférence successives, d'un procédé de fabrication du mode de réalisation de la figure 1.

La figure 2 représente une étape d'un exemple de procédé de fabrication du dispositif de la figure 1.

Cette étape comprend une étape de formation du niveau de métallisation MX comprenant les éléments 16.

Cette étape comprend la formation de la couche isolante 14. Des cavités traversant la couche 14 sont formées aux emplacements des éléments 16. Les cavités sont ensuite remplies du matériau des éléments 16, par exemple un métal, de préférence du cuivre ou du tungstène, de manière à former lesdits éléments 16. Les cavités sont remplies de manière à ce que le matériau des éléments 16 ne soit pas situé hors des cavités.

La figure 3 représente une étape d'un exemple de procédé de fabrication du dispositif de la figure 1.

Au cours de cette étape, un empilement 36 de couches est formé sur la couche 14 et sur les éléments 16. L'empilement 36 comprend, dans cet ordre à partir de la couche 14 :
- une couche isolante 38 ;
- une couche 40 en matériau à changement de phase ; et
- une couche isolante 42.

La couche isolante 38 est en le matériau de la portion couche 20 de l'empilement 18 de la figure 1, par exemple en nitrure de silicium. La couche 40 est en le matériau de la couche 22 de l'empilement 18 de la figure 1. La couche 42 est de préférence en le même matériau que la couche 24 de l'empilement 18 de la figure 1, par exemple en nitrure de silicium.

Similairement, l'épaisseur de la couche 38 correspond à l'épaisseur des couches 20 de la figure 1. L'épaisseur de la couche 40 correspond à l'épaisseur des couches 22 de la figure 1. L'épaisseur de la couche 42 correspond à l'épaisseur des couches 24 de la figure 1.

La figure 4 représente une étape d'un exemple de procédé de fabrication du dispositif de la figure 1.

Au cours de cette étape, une gravure est effectuée de manière à former des cavités 44 dans l'empilement 36. Chaque cavité 44 traverse l'empilement 36. Ainsi, le fond des cavités 44 correspond au niveau de la face supérieure de la couche 14. Le fond des cavités 44 comprend ainsi des portions des faces supérieures de la couche 14 et des éléments 16.

Les cavités 44 forment entre elles des bandes à partir de l'empilement 36. L'empilement 36 est gravé de manière à former une bande 46 pour chaque ligne de mot, c'est-à-dire pour chaque élément 16 correspondant à une ligne de mot. Chaque bande 36 comprend une bande 48 de la couche 38 correspondant à la couche 20 des empilements 18 des cellules de la ligne de mot, une bande 50 de la couche 40 correspondant la couche 22 des empilements 18 des cellules de la ligne de mot et une bande 52 de la couche 42 correspondant la couche 24 des empilements 18 des cellules de la ligne de mot. Les parois latérales des cavités 44 correspondent aux flancs des bandes 50.

Chaque bande 50 recouvre partiellement un élément 16 et recouvre partiellement la couche 14. Chaque bande 50 s'étend de préférence sur toute la longueur de l'élément 16.

Chaque bande 50 comprend une paroi latérale, ou un flanc, correspondant à la paroi sur laquelle repose l'élément 26 de la figure 1 et s'étendant sur l'élément 16, dans la direction de la ligne de mot. Ainsi, chaque élément 16 est partialement recouvert par une, de préférence une unique, bande 50. Chaque bande comprend une paroi latérale, ou un flanc, correspondant à la paroi sur laquelle repose l'élément 28 de la figure 1 et s'étendant sur la couche 14.

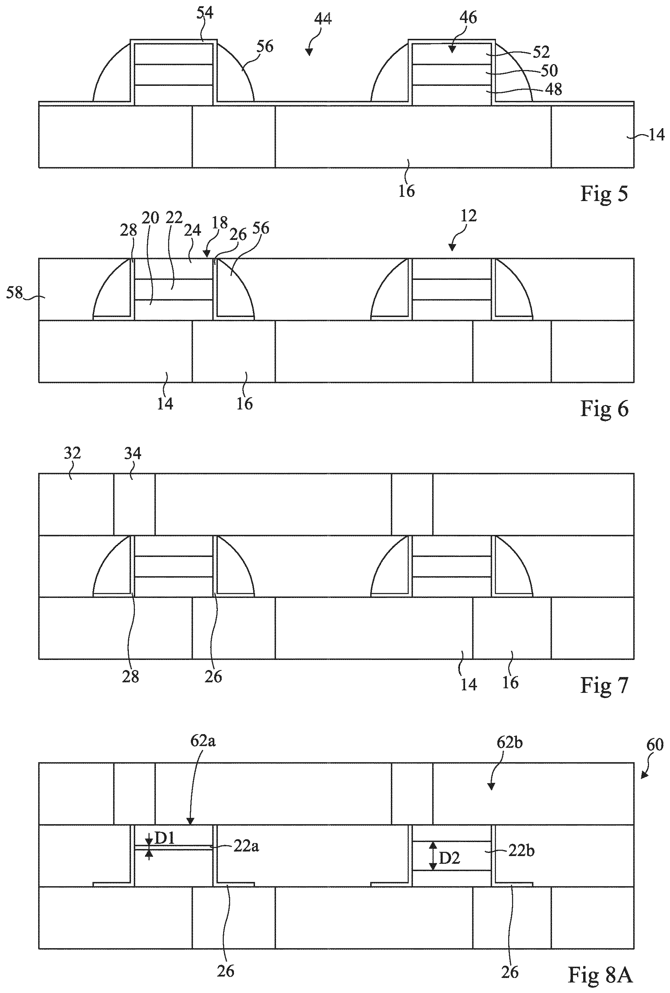

La figure 5 représente une étape d'un exemple de procédé de fabrication du dispositif de la figure 1.

Au cours de cette étape, une couche 54 en le matériau des éléments 26 et 28 est formée de manière conforme sur l'ensemble de la structure. La couche 54 recouvre en particulier les parois latérales de l'empilement 46 et les portions de la couche 14 et des éléments 16 situées aux pieds des empilements 46. En particulier, la couche 54 recouvre les parois latérales des couches 50. La couche 54 a de préférence une épaisseur sensiblement constante. L'épaisseur de la couche 54 est sensiblement égale à l'épaisseur des parties horizontales et verticales des éléments 26 et 28 de la figure 1.

L'étape de la figure 5 comprend en outre la formation d'espaceurs 56. Les espaceurs recouvrent la couche 54 au niveau des parois des cavités 44 et au pied des parois, de manière à recouvrir les portions de la couche 54 formant les éléments 26 et 28.

La figure 6 représente une étape d'un exemple de procédé de fabrication du dispositif de la figure 1.

L'étape de la figure 6 comprend une étape de gravure anisotrope de la couche 54, et plus particulièrement des portions de la couche 54 n'étant pas situées sous les espaceurs. Les éléments 26 et 28 en forme de L sont ainsi formés. Chaque cavité 44 comprend de préférence deux éléments 26 ou 28, de préférence un élément 26 et un élément 28, en forme de L, situés sur des parois opposées de la cavité 44. Chaque élément 26 ou 28 formé au cours de cette étape s'étend de préférence sur toute la longueur de la bande 46. La portion de la couche 54 située entre les éléments 26, 28 est retirée au cours de cette étape, les éléments 26, 28 n'étant ainsi pas en contact les uns avec les autres.

L'étape de la figure 6 comprend en outre l'individualisation des cellules 12. Plus précisément, les bandes 46, et les éléments 26 et 28 correspondants, sont gravés de manière à séparés les cellules destinées à être reliées par les mêmes lignes de mots.

L'étape de la figure 6 comprend en outre la formation d'une couche isolante 58. La couche 58 est en le matériau de la couche 30. La couche 58 et les espaceurs 56 forment la couche 30.

La couche 56 entourent latéralement les cellules 12. En particulier, la couche 58 recouvrent les parois latérales des empilements 18 n'étant pas recouverts par les éléments 26 et 28. L'épaisseur de la couche 58 est sensiblement égale à la hauteur des empilements 18. La face supérieure de la couche 58 est ainsi coplanaire avec la face supérieure des empilements 18 et des éléments 28. La couche 58 ne recouvre pas les extrémités supérieures des parties verticales des éléments 28.

La figure 7 représente une étape d'un exemple de procédé de fabrication du dispositif de la figure 1.

Cette étape comprend une étape de formation du niveau de métallisation MX+1 comprenant les éléments 34.

Cette étape comprend la formation de la couche isolante 32. Des cavités traversant la couche 32 sont formées aux emplacements des éléments 34. Plus précisément, une cavité est formée de manière à découvrir l'extrémité supérieure de chaque élément 28. Les cavités sont ensuite remplies du matériau des éléments 34, par exemple un métal, de préférence du cuivre ou du tungstène, de manière à former lesdits éléments 34. Les cavités sont remplies de manière à ce que le matériau des éléments 34 ne soit pas situé hors des cavités.

La figure 8A représente un autre mode de réalisation d'un dispositif électronique 60 comprenant des cellules mémoire 62a, 62b.

Le dispositif 60 comprend les éléments du dispositif 10 qui ne seront pas décrit en détail.

Le dispositif 60 diffère du dispositif 10 en ce que le dispositif 60 comprend au moins une cellule 62a et au moins une cellule 62b. La cellule 62a comprend une couche 22a, correspondant à la couche 22 de la figure 1, ayant une épaisseur D1. La cellule 62b comprend une couche 22b, correspondant à la couche 22 de la figure 1, ayant une épaisseur D2. Les épaisseurs D1 et D2 sont différentes. L'épaisseur D1 est inférieure à l'épaisseur D2. Par exemple, l'épaisseur D1 est sensiblement deux fois plus petite que l'épaisseur D2.

Les cellules 62a sont des cellules mémoire à deux états. Autrement dit, les cellules 62a peuvent être programmées de manière à contenir une valeur parmi deux valeurs, par exemple les valeurs binaires '0' et '1'. L'épaisseur D1 est par exemple comprise entre 5 nm et 50 nm. Ainsi, lorsqu'un courant traverse la cellule 62a, par exemple un courant compris entre 10 µA et 100 µA, tout le matériau à changement de phase en contact avec l'élément 26 bascule entre la phase amorphe et la phase cristalline. Ainsi, la cellule 62a comprend deux états : un premier état dans lequel la couche 22a est entièrement dans la phase amorphe et un deuxième état dans lequel tout le matériau à changement de phase en contact avec l'élément 26 est dans la phase cristalline.

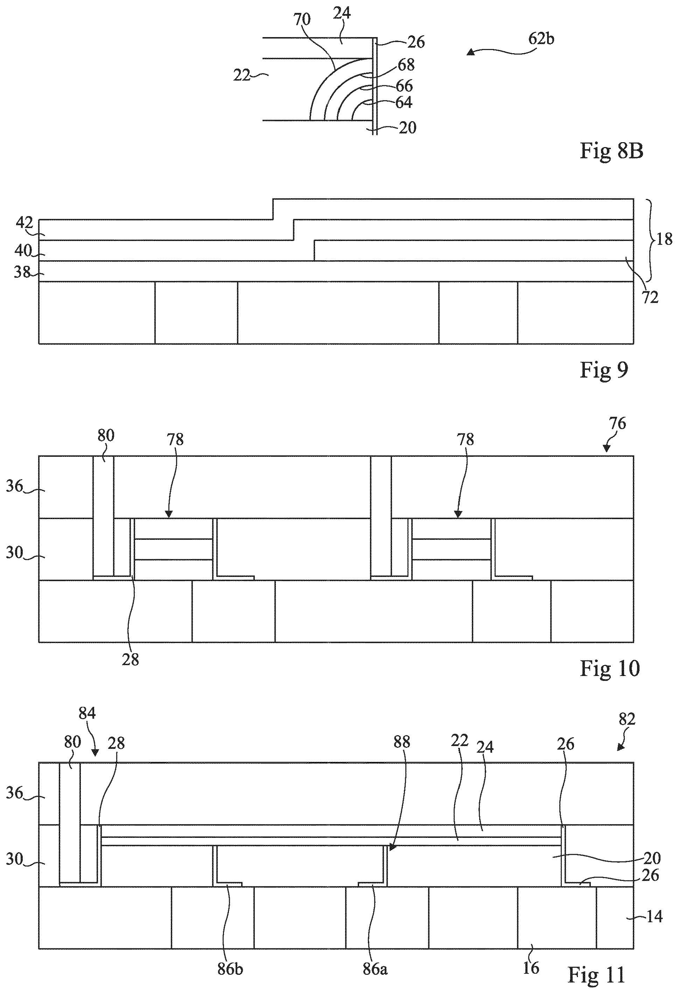

Les cellules 62b sont des cellules mémoire à multiples états, par exemple au moins trois états. Autrement dit, les cellules 62b peuvent être programmées de manière à contenir une valeur parmi au moins trois valeurs. L'épaisseur D2 est par exemple comprise entre 10 nm et 100 nm. Ainsi, lorsqu'un courant traverse la cellule 62b, par exemple un courant compris entre 10 µA et 100 µA, au moins une partie du matériau à changement de phase en contact avec l'élément 26 bascule entre la phase amorphe et la phase cristalline. Ainsi, la cellule 62a comprend différents états décrits plus en détail en relation avec la figure 8B.

La figure 8B représente différents états d'un exemple de cellule mémoire selon le mode de réalisation de la figure 8A.

La figure 8B représente une partie d'une cellule 62b. Plus précisément, la figure 8B représente une partie de l'élément 26, et une partie de l'empilement 18. La figure 8B représente une partie de la couche 22, plus précisément la partie en contact avec l'élément 26.

Dans l'exemple de la figure 8B, la cellule 62b peut contenir une valeur parmi cinq valeurs distinctes. Chaque valeur correspond à une valeur de résistivité entre l'élément 16 et l'élément 34, et plus précisément entre l'élément 26 et l'élément 28.

La figure 8B comprend des contours 64, 66, 68, 70 correspondants à la portion de la couche 22 basculant de la phase amorphe à la phase cristalline lors de la programmation d'une des valeurs.

La cellule 62b est programmée de manière à contenir une première valeur lorsque la couche 22 est entièrement amorphe. Aucun courant destiné à basculer la phase de la couche 22 n'a été appliqué entre les éléments 26 et 28.

La cellule 62b est programmée de manière à contenir une deuxième valeur lorsque la couche 22 comprend une portion, délimitée par le contour 64, ayant basculé à la phase cristalline. Ladite portion est par exemple située au niveau du coin inférieur de la couche 22 en contact avec l'élément 26. Ladite portion est par exemple obtenue en appliquant, entre les éléments 26 et 28, un courant ayant une valeur comprise dans une première gamme. La résistance entre l'élément 26 et l'élément 28 est ainsi supérieure à la valeur indiquant la première valeur et indique que la deuxième valeur a été programmée.

La cellule 62b est programmée de manière à contenir une troisième valeur lorsque la couche 22 comprend une portion, délimitée par le contour 66, ayant basculé à la phase cristalline. Ladite portion est par exemple située au niveau du coin inférieur de la couche 22 en contact avec l'élément 26. Ladite portion est plus importante que la portion correspondant à la deuxième valeur. Ladite portion inclue par exemple la portion correspondant à la deuxième valeur. Ladite portion est par exemple obtenue en appliquant, entre les éléments 26 et 28, un courant ayant une valeur comprise dans une deuxième gamme, les valeurs de la deuxième gamme étant par exemple supérieures aux valeurs de la première gamme. La résistance entre l'élément 26 et l'élément 28 est ainsi supérieure à la valeur indiquant la deuxième valeur et indique que la troisième valeur a été programmée.

La cellule 62b est programmée de manière à contenir une quatrième valeur lorsque la couche 22 comprend une portion, délimitée par le contour 68, ayant basculé à la phase cristalline. Ladite portion est par exemple située au niveau du coin inférieur de la couche 22 en contact avec l'élément 26. Ladite portion est plus importante que la portion correspondant à la troisième valeur. Ladite portion inclue par exemple la portion correspondant à la troisième valeur. Ladite portion est par exemple obtenue en appliquant, entre les éléments 26 et 28, un courant ayant une valeur comprise dans une troisième gamme, les valeurs de la troisième gamme étant par exemple supérieures aux valeurs de la deuxième gamme. La résistance entre l'élément 26 et l'élément 28 est ainsi supérieure à la valeur indiquant la troisième valeur et indique que la quatrième valeur a été programmée.

La cellule 62b est programmée de manière à contenir une cinquième valeur lorsque la couche 22 comprend une portion, délimitée par le contour 68, ayant basculé à la phase cristalline. Ladite portion correspond par exemple à l'ensemble de la paroi de la couche 22 en contact avec l'élément 26. Ladite portion est plus importante que la portion correspondant à la quatrième valeur. Ladite portion est par exemple obtenue en appliquant, entre les éléments 26 et 28, un courant ayant une valeur comprise dans une quatrième gamme, les valeurs de la quatrième gamme étant par exemple supérieures aux valeurs de la troisième gamme. La résistance entre l'élément 26 et l'élément 28 est ainsi supérieure à la valeur indiquant la quatrième valeur et indique que la cinquième valeur a été programmée.

La figure 9 représente une étape du procédé de fabrication du mode de réalisation de la figure 8.

Le procédé de fabrication du dispositif 60 est identique au procédé décrit en relation avec les figures 2 à 7, à l'exception de l'étape de la figure 3 qui est remplacée par l'étape de la figure 9. L'étape de la figure 9 diffère de l'étape de la figure 3 en ce que l'étape de la figure 3 comprend, entre la formation de la couche 38 et la formation de la couche 40, la formation d'une couche 72 aux emplacements des cellules 62b. La couche 74 n'est pas situées aux emplacements des cellules 62a.

L'épaisseur de la couche 74 correspond à la différence entre l'épaisseur D1 et l'épaisseur D2.

La figure 10 représente un autre mode de réalisation d'un dispositif électronique 76 comprenant des cellules mémoire 78.

Le dispositif 76 comprend les éléments du dispositif 10 de la figure 1 qui ne seront pas décrits de nouveau. Le dispositif 76 diffère du dispositif 10 en ce que le dispositif 76 ne comprend pas les éléments 34. Le dispositif 76 comprend des éléments conducteurs 80 traversant la couche 36 et la couche 30 de manière à atteindre les parties horizontales des éléments 28. Le dispositif 76 comprend autant d'éléments 80 que de cellule 78. Chaque élément 80 s'étend par exemple de la face supérieure de la couche 36 à la face supérieure d'une partie horizontale de l'élément 28.

La figure 11 représente un autre mode de réalisation d'un dispositif électronique 82 comprenant des cellules mémoire 84. Une unique cellule 84 est représentée en figure 11.

Le dispositif 82 comprend les éléments du dispositif 76 de la figure 10 qui ne seront pas décrit de nouveau. Le dispositif 82 diffère du dispositif 76 en ce que chaque cellule 84 comprend au moins un élément conducteur 86 situé dans la couche 20, de préférence deux éléments 86a, 86b. Chaque élément 86 a par exemple la forme d'un L. Chaque élément 86 comprend ainsi une partie horizontale d'étendant sur, et en contact avec, un élément 16, distinct de l'élément 16 en contact avec l'élément 26. Chaque élément 86 comprend aussi une partie verticale s'étendant de l'élément 16 à la couche 22, de préférence, de la face supérieure de l'élément 16 à la face inférieure de la couche 22. Les éléments 86 sont par exemple en le même matériau que les éléments 26, 28.

La cellule 82 est ainsi située au-dessus de trois éléments 16. Les trois éléments 16 sont agencés en ligne, par exemple dans la direction d'une ligne de bit.

Le procédé de fabrication du dispositif 82 diffère du procédé décrit en relation avec les figures 2 à 7 en ce que le procédé de fabrication du dispositif 82 comprend la formation de trois éléments 16 par cellule mémoire au lieu d'un élément 16. De plus, le procédé de fabrication du dispositif 82 diffère du procédé décrit en relation avec les figures 2 à 7 en ce que le procédé de fabrication du dispositif 82 comprend, entre la formation de la couche 20 et la formation de la couche 22, la formation des éléments 86.

La formation des éléments 86 dans la couche 20 est similaire à la formation des éléments 26, 28 dans l'empilement 18. La formation des éléments 86 comprend la formation d'une cavité 88 comprenant une paroi latérale au niveau de chaque élément 86. La formation des éléments 86 comprend ensuite la formation d'une couche conductrice en le matériau des éléments 86 de manière conforme sur l'ensemble de la structure. La formation des éléments 86 comprend la formation d'espaceurs recouvrant les portions de la couche conductrice correspondant aux éléments 86. Les espaceurs s'étendent par exemple du niveau de la face supérieure de la couche 14 au niveau de la face supérieure de la couche 20. La formation des éléments 86 comprend ensuite une étape de gravure anisotrope de manière à retirer les portions de la couche conductrice n'étant pas protégées par les espaceurs. La cavité est ensuite remplie d'un matériau isolant, par exemple le matériau de la couche 20.

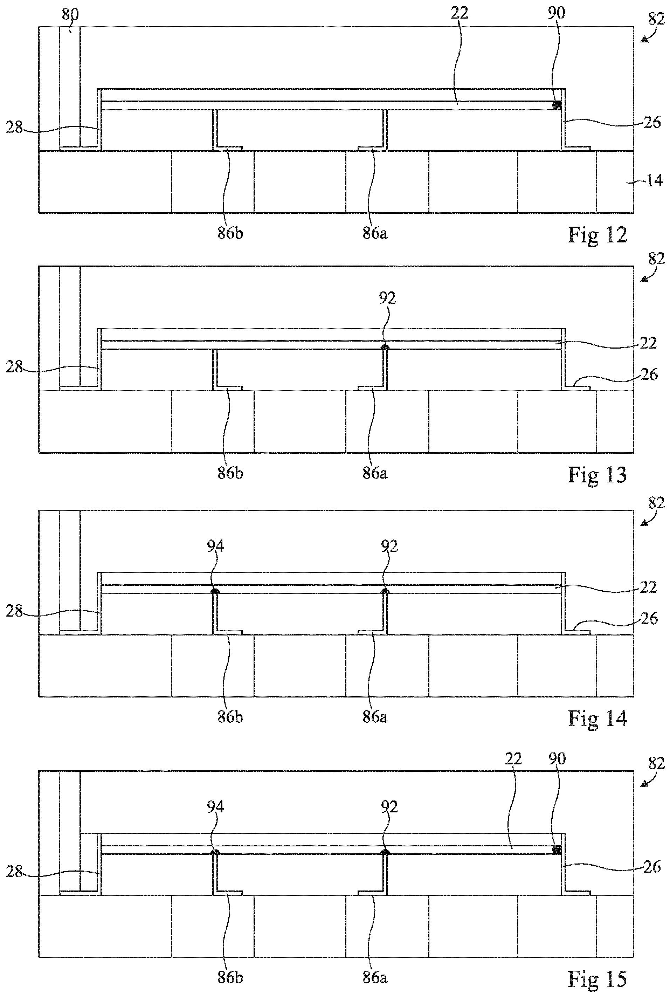

La figure 12, la figure 13, la figure 14 et la figure 15 représentent des états possibles du mode de réalisation de la figure 11.

La figure 12 représente un premier état possible du dispositif 82 de la figure 11. Plus précisément, la figure 12 représente le dispositif 82 contenant une première valeur.

Le dispositif 82 comprend une région 90 dans la couche 22, le matériau de la région 90 ayant basculé de la phase amorphe à la phase cristalline. La région 90 est située au niveau de l'interface entre la couche 22 et l'élément 26.

La première valeur est programmée en appliquant un courant entre les éléments 26 et 28. La valeur contenue dans la mémoire est lue en déterminant la résistance entre les éléments 26 et 28. Cette résistance prend une première valeur dans le cas de la figure 12.

La figure 13 représente un premier état possible du dispositif 82 de la figure 11. Plus précisément, la figure 13 représente le dispositif 82 contenant une deuxième valeur.

Le dispositif 82 comprend une région 92 dans la couche 22, le matériau de la région 92 ayant basculé de la phase amorphe à la phase cristalline. La région 92 est située au niveau de l'interface entre la couche 22 et l'élément 86a.

La deuxième valeur est programmée en appliquant un courant entre les éléments 86a et 28. La valeur contenue dans la mémoire est lue en déterminant la résistance entre les éléments 26 et 28. Cette résistance prend une deuxième valeur dans le cas de la figure 13. Ladite deuxième valeur de résistance est par exemple supérieure à la première valeur de résistance.

La figure 14 représente un premier état possible du dispositif 82 de la figure 11. Plus précisément, la figure 14 représente le dispositif 82 contenant une troisième valeur.

Le dispositif 82 comprend une région 94 dans la couche 22, le matériau de la région 94 ayant basculé de la phase amorphe à la phase cristalline. La région 94 est située au niveau de l'interface entre la couche 22 et l'élément 86b. Le dispositif 82 comprend en outre la région 92.

La troisième valeur est programmée en appliquant un courant entre les éléments 86b et 28 et entre les éléments 86a et 28, par exemple simultanément. La valeur contenue dans la mémoire est lue en déterminant la résistance entre les éléments 26 et 28. Cette résistance prend une troisième valeur dans le cas de la figure 14. Ladite troisième valeur de résistance est par exemple supérieure à la deuxième valeur de résistance.

La figure 15 représente un premier état possible du dispositif 82 de la figure 11. Plus précisément, la figure 15 représente le dispositif 82 contenant une quatrième valeur.

Le dispositif 82 comprend les régions 90, 92 et 94. La quatrième valeur est programmée en appliquant un courant entre les éléments 86b et 28, entre les éléments 86a et 28, et entre les éléments 26 et 28, par exemple simultanément. La valeur contenue dans la mémoire est lue en déterminant la résistance entre les éléments 26 et 28. Cette résistance prend une quatrième valeur dans le cas de la figure 15. Ladite quatrième valeur de résistance est par exemple supérieure à la troisième valeur de résistance.

Le dispositif 82 de la figure 11 peut être dans un cinquième état, de manière à contenir une cinquième valeur. Dans le cinquième état, la couche 22 est entièrement amorphe. La résistance entre les éléments 26 et 28 prend donc une cinquième valeur.

Le dispositif 82 de la figure 11 peut être dans un sixième état, de manière à contenir une sixième valeur. Dans le sixième état, la couche 22 comprend uniquement la région 94.

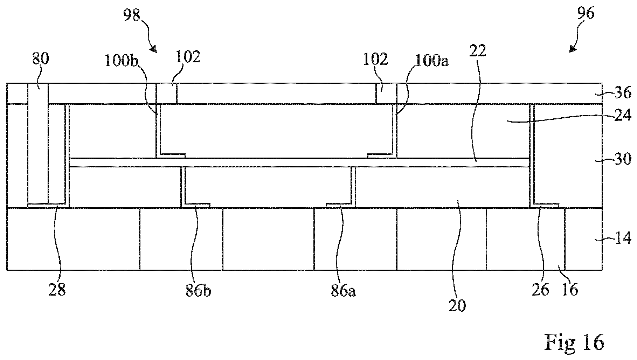

La figure 16 représente un autre mode de réalisation d'un dispositif électronique 96 comprenant des cellules mémoire 98. Une unique cellule 98 est représentée en figure 16.

Le dispositif 96 comprend les éléments du dispositif 82 de la figure 11 qui ne seront pas décrit de nouveau. Le dispositif 96 diffère du dispositif 82 en ce que le dispositif 96 comprend au moins un élément conducteur 100 situé dans la couche 24, de préférence deux éléments 100a, 100b. Chaque élément 100 a par exemple la forme d'un L. Chaque élément 100 comprend ainsi une partie horizontale d'étendant sur, et en contact avec, la couche 22. Chaque élément 100 comprend aussi une partie verticale s'étendant de la couche 22 à la couche 32, de préférence, de la face supérieure de la couche 22 à la face supérieure de la couche 24. Les éléments 100 sont par exemple en le même matériau que les éléments 26, 28.

Le dispositif 96 comprend des éléments conducteurs 102. Les éléments 102 sont par exemple en métal, par exemple en cuivre. Les éléments 102 sont par exemple des métallisations du niveau MX+1. Chaque élément 102 est en contact avec une extrémité supérieure d'un élément 100.

Il est ainsi possible de programmer, et de lire plusieurs données dans la cellule 98. Par exemple, une valeur est déterminée par la résistance entre les éléments 26 et 28, une autre valeur est déterminée par la résistance entre les éléments 86a et 100a et une autre valeur est déterminée par la résistance entre les éléments 86b et 100b.

Par exemple, une première donnée binaire peut être programmée entre les éléments 26 et 28, une deuxième donnée binaire peut être programmée entre les éléments 86a et 100a et une troisième donnée binaire peut être programmée entre les éléments 86b et 100b. Par exemple, la première donnée est égale à une première valeur si la couche 22 est entièrement en phase amorphe et à une deuxième valeur si la couche 22 comprend une région en phase cristalline. La région en phase cristalline correspond par exemple à la région 90 de la figure 12, à la région 92 de la figure 13, à la région 94 de la figure 14 ou à une combinaison des régions 90, 92, 94. Par exemple, la deuxième valeur est égale à une première valeur si la couche 22 comprend la région 92 et à une deuxième valeur si la couche 22 ne comprend pas la région 92, c'est-à-dire si la portion de la couche 22 entre les éléments 86a et 100a est entièrement en phase amorphe. Par exemple, la troisième valeur est égale à une première valeur si la couche 22 comprend la région 94 et à une deuxième valeur si la couche 22 ne comprend pas la région 94, c'est-à-dire si la portion de la couche 22 entre les éléments 86b et 100b est entièrement en phase amorphe.

Un avantage des modes de réalisation décrits précédemment est qu'il est possible de fabriquer une cellule mémoire s'intégrant dans un niveau de métallisation d'un réseau d'interconnexion.

Un avantage des modes de réalisation décrits est que la couche 22 est confinée, c'est à dire que la couche 22 chauffe directement lorsqu'elle est traversée par un courant, au lieu d'être chauffé indirectement par un élément résistif qui chaufferait et transfèrerait la chaleur. La perte d'énergie, et donc la consommation d'énergie, est ainsi diminuée.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus, l'invention étant définie par les revendications.

## Revendications

1. Dispositif (10, 60, 76, 82 96) comprenant une cellule mémoire à changement de phase (12, 62a, 62b, 78, 84, 98), la cellule mémoire comprenant un premier empilement de couches (18), le premier empilement de couches (18) comprenant une couche intermédiaire (22) de matériau à changement de phase, une couche inférieure isolante (20) et une couche supérieure isolante (24), la cellule comprenant des premier (26) et deuxième (28) éléments conducteurs ayant une forme de L, le premier élément (26) s'étendant sur une première paroi latérale du premier empilement, le deuxième élément (28) s'étendant sur une deuxième paroi latérale de l'empilement opposée à la première paroi, dans lequel la couche intermédiaire (22) de l'empilement de couches (18) est configurée pour qu'un état parmi cristallin et amorphe d'au moins une région de la couche intermédiaire (22) détermine un état programmé de la cellule à changement de phase.

2. Procédé de fabrication d'un dispositif (10, 60, 76, 82 96) comprenant une cellule mémoire à changement de phase (12, 62a, 62b, 78, 84, 98), le procédé comprenant une étape de formation d'un premier empilement de couches (18), le premier empilement de couches (18) comprenant une couche intermédiaire (22) de matériau à changement de phase, une couche inférieure isolante (20) et une couche supérieure isolante (24), le procédé comprenant en outre la formation de premier (26) et deuxième (28) éléments conducteurs ayant une forme de L, le premier élément (26) s'étendant sur une première paroi latérale du premier empilement, le deuxième élément (28) s'étendant sur une deuxième paroi latérale du premier opposée à la première paroi, dans lequel la couche intermédiaire (22) de l'empilement de couches (18) est configurée pour qu'un état parmi cristallin et amorphe d'au moins une région de la couche intermédiaire (22) détermine un état programmé de la cellule à changement de phase.

3. Dispositif selon la revendication 1 ou procédé selon la revendication 2, dans lequel la couche intermédiaire a une épaisseur comprise entre 5 nm et 50 nm.

4. Dispositif selon la revendication 1 ou 3 ou procédé selon la revendication 2 ou 3, dans lequel le dispositif comprend un réseau d'interconnexion, la cellule (12, 62a, 62b, 78, 84, 98) étant située entre un niveau inférieur et un niveau supérieur du réseau d'interconnexion, les niveaux inférieur et supérieur étant successifs.

5. Dispositif ou procédé selon la revendication 4, dans lequel le premier élément conducteur (26) comprend une partie horizontale reposant sur un troisième élément conducteur (16) du niveau inférieur et une partie verticale s'étendant sur la paroi latérale du premier empilement.

6. Dispositif ou procédé selon la revendication 4 ou 5, dans lequel un quatrième élément conducteur (34) du niveau supérieur est en contact avec une extrémité supérieure d'une partie verticale du deuxième élément (28).

7. Dispositif ou procédé selon la revendication 4 ou 5, dans lequel un cinquième élément conducteur (80) s'étend du niveau supérieur à une partie horizontale du deuxième élément conducteur (28).

8. Procédé selon l'une quelconque des revendications 4 à 7, dans lequel le procédé comprend la formation du niveau d'interconnexion inférieur, la formation d'un deuxième empilement (36) de couches comprenant une première couche (40) en un matériau à changement de phase entre deux deuxièmes couches isolantes (38, 42), la formation de cavités traversant le deuxième empilement de manière à former le premier empilement, une paroi de chaque premier empilement étant située sur un troisième élément.

9. Procédé selon la revendication 8, dans lequel le procédé comprend la formation de manière conforme d'une troisième couche (54) en le matériau des premier et deuxième éléments, la formation d'espaceurs (56) sur les parois latérales du premier empilement (18) et la gravure des portions de la troisième couche n'étant pas situées sous les espaceurs.

10. Dispositif selon l'une quelconque des revendications 1, ou 3 à 7 ou procédé selon l'une quelconque des revendications 2 à 9, dans lequel le dispositif comprend au moins deux cellules (62a, 62b) dont les couches intermédiaires (22a, 22b) ont des épaisseurs différentes.

11. Dispositif ou procédé selon la revendication 10, dans lequel la couche intermédiaire (22a) d'une des cellules (62a) a une épaisseur comprise entre 5 nm et 50 nm et dans lequel la couche intermédiaire (22b) de l'autre des cellules (62b) a une épaisseur comprise entre 10 nm et 100 nm.

12. Procédé selon la revendication 10 ou 11, dans lequel le procédé comprend une étape de formation d'une couche (72) d'épaisseur égale à la différence entre les épaisseurs des couches intermédiaires des deux cellules (62a, 62b) sur l'emplacement de la cellule ayant l'épaisseur la plus grande.

13. Dispositif selon l'une quelconque des revendications 1, 3 à 7, 10 ou 11 ou procédé selon l'une quelconque des revendications 2 à 12, dans lequel le dispositif comprend des sixièmes éléments conducteurs (86) en forme de L s'étendant à travers la couche inférieure du premier empilement.

14. Dispositif selon l'une quelconque des revendications 1, 3 à 7, 10, 11 ou 13 ou procédé selon l'une quelconque des revendications 2 à 13, dans lequel le dispositif comprend des septièmes éléments conducteurs (100) en forme de L s'étendant à travers la couche supérieure du premier empilement.

## Patentansprüche

1. Vorrichtung (10, 60, 76, 82, 96) mit einer Phasenwechsel-Speicherzelle (12, 62a, 62b, 78, 84, 98), wobei die Speicherzelle einen ersten Stapel von Schichten (18) aufweist, wobei der erste Stapel von Schichten (18) eine Zwischenschicht (22) aus Phasenwechselmaterial, eine untere Isolierschicht (20) und eine obere Isolierschicht (24) aufweist, wobei die Zelle L-förmige erste (26) und zweite (28) leitende Elemente aufweist, wobei sich das erste Element (26) auf einer ersten Seitenwand des ersten Stapels erstreckt, wobei sich das zweite Element (28) auf der zweiten Seitenwand des Stapels gegenüber der ersten Wand erstreckt, wobei die Zwischenschicht (22) des Stapels von Schichten (18) so konfiguriert ist, dass ein Zustand aus kristallin und amorph von mindestens einem Bereich der Zwischenschicht (22) den programmierten Zustand der Phasenwechsel-Speicherzelle bestimmt.

2. Herstellungsverfahren einer Vorrichtung (10, 60, 76, 82, 96) mit einer Phasenwechsel-Speicherzelle (12, 62a, 62b, 78, 84, 98), wobei das Verfahren einen Schritt des Ausbildens eines ersten Stapels von Schichten (18) aufweist, wobei der erste Stapel von Schichten (18) eine Zwischenschicht (22) aus Phasenwechselmaterial, eine untere Isolierschicht (20) und eine obere Isolierschicht (24) aufweist, wobei das Verfahren ferner das Ausbilden von L-förmigen ersten (26) und zweiten (28) leitenden Elementen aufweist, wobei sich das erste Element (26) auf einer ersten Seitenwand des ersten Stapels erstreckt, wobei sich das zweite Element (28) auf einer zweiten Seitenwand des Stapels gegenüber der ersten Wand erstreckt, wobei die Zwischenschicht (22) des Stapels von Schichten (18) so konfiguriert ist, dass ein Zustand aus kristallin und amorph von mindestens einem Bereich der Zwischenschicht (22) den programmierten Zustand der Phasenwechsel-Speicherzelle bestimmt.

3. Vorrichtung nach Anspruch 1 oder Verfahren nach Anspruch 2, wobei die Zwischenschicht eine Dicke zwischen 5 nm und 50 nm aufweist.

4. Vorrichtung nach Anspruch 1 oder 3 oder Verfahren nach Anspruch 2 oder 3, wobei die Vorrichtung ein Verbindungsnetzwerk aufweist, wobei die Zelle (12, 62a, 62b, 78, 84, 98) zwischen einer unteren Ebene und einer oberen Ebene des Verbindungsnetzwerks angeordnet ist, wobei die untere und die obere Ebene aufeinander folgen.

5. Vorrichtung oder Verfahren nach Anspruch 4, wobei das erste leitende Element (26) einen horizontalen Teil, der auf einem dritten leitenden Element (16) der unteren Ebene liegt, und einen vertikalen Teil aufweist, der sich an der Seitenwand des ersten Stapels erstreckt.

6. Vorrichtung oder Verfahren nach Anspruch 4 oder 5, wobei ein viertes leitendes Element (34) der oberen Ebene in Kontakt mit einem oberen Ende eines vertikalen Teils des zweiten Elements (28) steht.

7. Vorrichtung oder Verfahren nach Anspruch 4 oder 5, wobei sich ein fünftes leitendes Element (80) von der oberen Ebene zu einem horizontalen Teil des zweiten leitenden Elements (28) erstreckt.

8. Verfahren nach einem der Ansprüche 4 bis 7, wobei das Verfahren Folgendes aufweist: das Ausbilden der unteren Verbindungsebene, das Ausbilden eines zweiten Stapels von Schichten (36), der eine erste Schicht (40) aus einem Phasenwechselmaterial zwischen zwei zweiten isolierenden Schichten (38, 42) aufweist, das Ausbilden von Hohlräumen, die sich durch den zweiten Stapel erstrecken, um den ersten Stapel zu bilden, aufweist, wobei eine Wand jedes ersten Stapels auf dem dritten Element angeordnet ist.

9. Vorrichtung oder Verfahren nach Anspruch 8, wobei das Verfahren das konforme Ausbilden einer dritten Schicht (54) in dem Material der ersten und zweiten Elemente, das Ausbilden von Abstandshaltern (56) an den Seitenwänden des ersten Stapels (18) und das Ätzen von Teilen der dritten Schicht, die sich nicht unter den Abstandshaltern befinden, aufweist.

10. Vorrichtung nach einem der Ansprüche 1 oder 3 bis 7 oder Verfahren nach einem der Ansprüche 2 bis 9, wobei die Vorrichtung mindestens zwei Zellen (62a, 62b) aufweist, deren Zwischenschichten (22a, 22b) unterschiedliche Dicken aufweisen.

11. Vorrichtung oder Verfahren nach Anspruch 10, wobei die Zwischenschicht (22a) einer der Zellen (62a) eine Dicke zwischen 5 nm und 50 nm aufweist und wobei die Zwischenschicht (22b) der anderen Zellen (62b) eine Dicke zwischen 10 nm und 100 nm aufweist.

12. Verfahren nach Anspruch 10 oder 11, wobei das Verfahren einen Schritt des Ausbildens einer Schicht (72) mit einer Dicke, die gleich der Differenz zwischen den Dicken der Zwischenschichten der beiden Zellen (62a, 62b) ist, an der Stelle der Zelle mit der größeren Dicke aufweist.

13. Vorrichtung nach einem der Ansprüche 1, 3 bis 7, 10 oder 11 oder Verfahren nach einem der Ansprüche 2 bis 12, wobei die Vorrichtung sechste L-förmige leitende Elemente (86) aufweist, die sich über die untere Schicht des ersten Stapels erstrecken.

14. Vorrichtung nach einem der Ansprüche 1, 3 bis 7, 10, 11 oder 13 oder Verfahren nach einem der Ansprüche 2 bis 13, wobei die Vorrichtung siebte L-förmige leitende Elemente (100) aufweist, die sich über die obere Schicht des ersten Stapels erstrecken.

## Claims

1. Device (10, 60, 76, 82 96) comprising a phase change memory cell (12, 62a, 62b, 78, 84, 98), the memory cell comprising a first stack of layers (18), the first stack of layers (18) comprising an intermediate layer (22) of phase change material, a lower insulating layer (20) and an upper insulating layer (24), the cell comprising L-shaped first (26) and second (28) conductive elements, the first element (26) extending on a first side wall of the first stack, the second element (28) extending on the second side wall of the stack opposite to the first wall, wherein the intermediate layer (22) of the stack of layers (18) is configured so that a state among crystalline and amorphous of at least one region of the intermediate layer (22) determines the programmed state of the phase change memory cell.

2. Manufacturing method of a device (10, 60, 76, 82 96) comprising a phase change memory cell (12, 62a, 62b, 78, 84, 98), the method comprising a step of formation of a first stack of layers (18), the first stack of layers (18) comprising an intermediate layer (22) of phase change material, a lower insulating layer (20) and an upper insulating layer (24), the method further comprising the formation of L-shaped first (26) and second (28) conductive elements, the first element (26) extending on a first side wall of the first stack, the second element (28) extending on a second side wall of the stack opposite to the first wall, wherein the intermediate layer (22) of the stack of layers (18) is configured so that a state among crystalline and amorphous of at least one region of the intermediate layer (22) determines the programmed state of the phase change memory cell.

3. Device according to claim 1 or method according to claim 2, wherein the intermediate layer has a thickness between 5 nm and 50 nm.

4. Device according to claim 1 or 3 or method according to claim 2 or 3, wherein the device comprises an interconnection network, the cell (12, 62a, 62b, 78, 84, 98) being located between a lower level and an upper level of the interconnection network, the lower and upper levels being successive.

5. Device or method according to claim 4, wherein the first conductive element (26) comprises a horizontal part lying on a third conductive element (16) of the lower level and a vertical part extending on the side wall of the first stack.

6. Device or method according to claim 4 or 5, wherein a fourth conductive element (34) of the upper level is in contact with an upper end of a vertical part of the second element (28).

7. Device or method according to claim 4 or 5, wherein a fifth conductive element (80) extends from the upper level to a horizontal part of the second conductive element (28).

8. Method according to any one of claims 4 to 7, wherein the method comprises the formation of the lower interconnection level, the formation of a second stack of layers (36) comprising a first layer (40) in a phase change material between two second insulating layers (38, 42), the formation of cavities extending through the second stack so as to form the first stack, a wall of each first stack being located on the third element.

9. Device or method according to claim 8, wherein the method comprises the conformal formation of a third layer (54) in the material of the first and second elements, the formation of spacers (56) on the side walls of the first stack (18) and the etching of portions of the third layer that are not located under the spacers.

10. Device according to any one of claims 1, or 3 to 7 or method according to any one of claims 2 to 9, wherein the device comprises at least two cells (62a, 62b) whose intermediate layers (22a, 22b) have different thicknesses.

11. Device or method according to claim 10 wherein the intermediate layer (22a) of one of the cells (62a) has a thickness between 5 nm and 50 nm and wherein the intermediate layer (22b) of the other cells (62b) has a thickness between 10 nm and 100 nm.

12. Method according to claim 10 or 11, wherein the method comprises a step of formation of a layer (72) of thickness equal to the difference between the thicknesses of the intermediate layers of the two cells (62a, 62b) on the location of the cell having the greater thickness.

13. Device according to any one of claims 1, 3 to 7, 10 or 11 or method according to any one of claims 2 to 12, wherein the device comprises sixth L-shaped conductive elements (86) extending across the lower layer of the first stack.

14. Device according to any one of claims 1, 3 to 7, 10, 11 or 13 or method according to any one of claims 2 to 13, wherein the device comprises seventh L-shaped conductive elements (100) extending across the upper layer of the first stack.
